**Europäisches Patentamt**

**European Patent Office**

**Office européen des brevets**

(19)

(11) Veröffentlichungsnummer : **0 154 624**
**B1**

(12) **EUROPÄISCHE PATENTSCHRIFT**

(45) Veröffentlichungstag der Patentschrift :
**17.08.88**

(21) Anmeldenummer : **84901738.9**

(22) Anmeldetag : **12.04.84**

(86) Internationale Anmeldenummer :
**PCT/DE 84/00089**

(87) Internationale Veröffentlichungsnummer :
**WO/8404193 (25.10.84 Gazette 84/25)**

(51) Int. Cl.⁴ : **G 09 G   3/00**, G 03 B 35/16,
G 02 B 27/22, A 61 B   6/02

(54) EINRICHTUNG ZUM ERZEUGEN VOLLSTÄNDIGER DREIDIMENSIONALER DARSTELLUNGEN EINES RÄUMLICHEN OBJEKTES.

(30) Priorität : **13.04.83 DE 3313217**

(43) Veröffentlichungstag der Anmeldung :
**18.09.85 Patentblatt 85/38**

(45) Bekanntmachung des Hinweises auf die Patenterteilung : **17.08.88 Patentblatt 88/33**

(84) Benannte Vertragsstaaten :
**BE CH DE FR GB LI LU NL**

(56) Entgegenhaltungen :
**DE-A- 2 830 115**
**FR-A-   506 097**

(73) Patentinhaber : **Bruker Medizintechnik GmbH**
**Silberstreifen**
**D-7512 Rheinstetten-Forchheim (DE)**

(72) Erfinder : **KNÜTTEL, Alexander**
**Baumgartenstrasse 5**
**D-7512 Rheinstetten 2 (DE)**
Erfinder : **KNÜTTEL, Bertold**
**Baumgartenstrasse 5**
**D-7512 Rheinstetten 2 (DE)**

(74) Vertreter : **Patentanwälte Kohler - Schwindling -**
**Späth**
**Hohentwielstrasse 41**
**D-7000 Stuttgart 1 (DE)**

## Beschreibung

Die Erfindung geht aus von einer Einrichtung zum Erzeugen vollständiger dreidimensionaler Darstellungen eines räumlichen Objektes mit einem Bildgeber, auf dem zeitlich nacheinander zweidimensionale, räumlich hintereinanderliegenden Schnitten entsprechende Bilder dargestellt werden und mit zwischen dem Bildgeber und einem Betrachter angeordneten, optischen Abbildungsmitteln, die ein im Raum stehendes zweites, virtuelles Bild der ersten Bilder erzeugen, wobei die optischen Abbildungsmittel ein vom Bildgeber synchron gesteuertes Element umfaßt, das die räumliche Lage des zweiten Bildes relativ zum Betrachter in Abhängigkeit von der zeitlichen Folge der ersten Bilder variiert.

Es sind bereits zahlreiche Verfahren und Einrichtungen bekannt geworden, mit denen dreidimensionale Darstellungen möglich sind. Bei einer ersten bekannten Art wird ein zweidimensionales Bild mit in eine bestimmte Richtung weisenden Schatten versehen, so daß ein dreidimensionaler Eindruck entsteht. Dieses Verfahren macht sich jedoch lediglich eine optische Täuschung zunutze und erhöht nicht den Informationsgehalt der Darstellung.

Bei einem anderen bekannten Verfahren wird von einer Zweiaugen-Aufnahmetechnik ausgegangen, beispielsweise mit zwei im Augenabstand voneinander angeordneten Kameras. Der dreidimensionale Eindruck beim Betrachter kann bei diesem Verfahren dadurch erzeugt werden, daß die beiden Aufnahmekanäle in unterschiedlichen Farben arbeiten und der Betrachtung eine Brille trägt, deren eines Glas in der einen Farbe und deren anderes Glas in der anderen Farbe gefärbt ist. Entsprechende Verfahren sind auch mit polarisiertem Licht und entsprechend polarisierten Brillen bekannt geworden. Zwar weist diese Art der dreidimensionalen Darstellung einen höheren Informationsgehalt auf, dieser geht jedoch nicht über die Summe des Informationsgehaltes zweier zweidimensionaler Darstellungen hinaus, die von den beiden Aufnahmeelementen erhalten werden. Dem Betrachter bietet sich vielmehr lediglich eine räumliche Darstellung an, die derjenigen eines feststehenden Betrachters gegenüber einem real vorhandenen räumlichen Objekt entspricht.

Weiterhin sind Einrichtungen und Verfahren zum Erzeugen dreidimensionaler Darstellungen bekannt geworden, die auf dem Prinzip der Holographie beruhen. Dabei wird ein dreidimensionales Objekt von einem Beobachtungsstrahl, üblicherweise einem Laserstrahl, beleuchtet und das vom Objekt reflektierte Licht mit einem Referenzstrahl gemischt. Das sich ergebende Interferenzmuster wird in der holographischen Aufnahme gespeichert, so daß bei geeigneter Beleuchtung der entwickelten holographischen Aufnahme ein dreidimensionaler Eindruck entsteht. Bei dieser Art der Darstellung ist der dreidimensionale Eindruck vollständiger als bei dem letztgenannten Verfahren, weil aufgrund der holographischen Aufnahmetechnik der Betrachter « um das Objekt herum » gehen kann, da die Oberfläche des abgebildeten Objektes frei im Raum zu schweben scheint.

Schließlich ist aus der DE-A-28 30 115 noch eine Vorrichtung zur Erzielung dreidimensional erscheinender Bilder bekannt, bei der auf einem Bildschirm zeitlich nacheinander Bilder dargestellt werden und der Bildschirm von einem Betrachter über einen gewölbten Spiegel betrachtet wird, dessen Wölbung synchron zur zeitlich aufeinanderfolgenden Bilddarstellung auf dem Bildschirm in der Tiefe moduliert wird. Der Betrachter sieht dabei über den Spiegel zeitlich nacheinander unterschiedliche Bilder in hintereinander angeordneten Stellungen des Spiegels, so daß sich für ihn eine dreidimensionale Darstellung ergibt.

Die bekannte Anordnung hat jedoch den Nachteil, daß ein verhältnismäßig großer auslenkbarer Spiegel verwendet wird, der die Gestalt eines am Rande eingespannten Hohlspiegels mit veränderlicher Wölbung hat und anstelle einer Lautsprechermembran in einem Lautsprechergehäuse angeordnet ist und von der Erregerspule des Lautsprechers ausgelenkt wird. Diese Anordnung ist mechanisch sehr aufwendig und damit auch störanfällig. So muß beispielsweise zum Erzielen der für eine flimmerfreie Bilddarstellung erforderlichen Auslenkfrequenz von ca. 25 Hz ein mechanischer Resonator vorgesehen werden, der eine derartige schnelle Auslenkung eines größeren Spiegels überhaupt erst ermöglicht. Weiterhin treten durch die Wölbungsänderung stetige Modulation der Bildgröße auf, die durch ein aufwendiges Computerprogramm kompensiert werden müssen. Schließlich ergibt sich aufgrund des verwendeten mechanischen Resonators eine zeitlich sinusförmige Auslenkung des Spiegels, so daß die Änderungsgeschwindigkeit der räumlichen Auslenkung in den Extremlagen minimal und im Nulldurchgang maximal ist. Aufgrund dieser Nichtlinearität muß auch die Bildfolgefrequenz auf dem Bildschirm in der Weise angepaßt werden, daß die aufeinanderfolgenden Bilder während des Nulldurchganges des Hohlspiegels in besonders schneller Folge abgebildet werden und in den Extremstellungen entsprechend langsamer. Diese Erhöhung der Darstellungsfrequenz führt jedoch zu erheblichen Datenverarbeitungsproblemen, insbesondere in Anbetracht der bereits erwähnten notwendigen Kompensation von Abbildungsfehlern, so daß insgesamt nur die Darstellung weniger Bildpunkt möglich ist, da mit verfügbaren Datenverarbeitungsanlagen der erforderliche schnelle Bildwechsel einschließlich der erforderlichen Bildkompensation bei hochaufgelösten Bildern, d.h. Bildern mit vielen Bildpunkten, nicht möglich ist.

Der Erfindung liegt demgegenüber die Aufgabe zugrunde, eine Einrichtung der eingangs genannten Art dahingehend weiterzubilden, daß die Notwendigkeit, das Schirmbild im Hinblick auf die zweidimensionale Darstellung und ihre zeitliche Abfolge zu kompensieren, entfällt.

Diese Aufgabe wird erfindungsgemäß dadurch gelöst, daß die optischen Abbildungsmittel zum verkleinerten Abbilden der auf dem Bildgeber dargestellten ersten Bilder in der Ebene des Elements und zum anschließenden Rückvergrößern in die Ebene des zweiten Bildes ausgebildet sind.

Die erfindungsgemäß verwendeten mechanisch bewegten Elemente, nämlich entweder ein Planspiegel oder eine Anordnung mit optischen Keilen, können daher aufgrund der zunächst vorgenommenen Verkleinerung des Bildes sehr klein ausgebildet werden, so daß nur geringe Massen bewegt werden müssen. Dies gestattet eine zeitlich streng lineare Auslenkung der mechanisch bewegten Elemente, so daß eine Korrektur der zeitlichen Bilddarstellung entfällt.

In besonders bevorzugter Ausgestaltung der Erfindung wird die Einrichtung in Verbindung mit einem Tomographen verwendet. Hierunter versteht man ein Gerät zum Untersuchen von Meßkörpern, bei dem hintereinanderliegende Schnittdarstellungen durch den Meßkörper hergestellt werden. Besonders bekannt sind im medizinischen Bereich die Röntgen-Computer-Tomographie und die Kernspin-Tomographie. Dabei werden von einem Patienten oder einem Körperteil eines Patienten Schnittdarstellungen angefertigt, die räumlich hintereinander liegen und jeweils vollständige Informationen in zwei, insgesamt also in drei Raumkoordinaten über den untersuchten Organbereich liefern. Die den räumlich hintereinanderliegenden Schnitten entsprechenden Bilder sind dabei in einem Rechner abgespeichert und können in kurzer zeitlicher Abfolge nacheinander auf einem Bildschirm dargestellt werden.

Sieht man nun in der Strecke zwischen dem Betrachter und dem Bildschirm ein Element vor, das die räumliche Positionierung zwischen Bildschirm und Betrachter in Synchronisation mit der aufeinanderfolgenden Bilddarstellung verändert, entsteht für den Betrachter im Sinne der eingangs gemachten Ausführungen zur DE-A-28 30 115 eine vollständige dreidimensionale Darstellung. Diese Darstellung hat gegenüber der holographischen Darstellung den weiteren Vorteil, daß nicht nur die Oberfläche des abzubildenden Objektes, sondern der gesamte Raumbereich dargestellt wird, so daß bei Abbildung von Tomogrammen eine vollständige dreidimensionale Darstellung des Inneren eines lebenden menschlichen Körpers möglich ist. Dabei kann der Betrachter — selbstverständlich in den Grenzen der jeweils verwendeten optischen Elemente in einem gewissen Winkelbereich — « um das Objekt herum » sehen, insbesondere auch hinter vorne liegenden Organen dahinterliegende weitere Organe erkennen.

Bei Verwendung von Datenverarbeitungsanlagen mit entsprechend hoher Datenverarbeitungsgeschwindigkeit können in Zukunft sogar Messungen on line vorgenommen werden, d. h. es ist evtl. eine vollständige dreidimensionale Betrachtung des Inneren eines lebenden menschlichen Körpers und der Bewegung der Organe, beispielsweise der Atmungsorgane und der Kreislauforgane, möglich.

In besonders bevorzugter Ausgestaltung der Erfindung umfassen die optischen Mittel mindestens zwei Sammelelemente, die zueinander in einem Abstand angeordnet sind, der der Summe ihrer Brennweiten entspricht. Diese Anordnung hat den besonderen Vorteil, daß trotz der Verkleinerung und Rückvergrößerung des vom Bildgeber dargestellen Bildes auch bei Auslenkung des optischen Elementes, beispielsweise des Planspiegels, ein konstanter Abbildungsmaßstab für das vom Betrachter gesehene Bild gewährleistet ist. Dies bringt den ganz entscheidenden Vorteil mit sich, daß die bildliche Darstellung in der Ebene nicht korrigiert zu werden braucht, wie dies bei Hohlspiegeln mit veränderlicher Krümmung entsprechend dem Stand der Technik der Fall ist. Zusammen mit der zeitlich linearen Auslenkung des Spiegels bzw. Keiles führt dies zu einer außerordentlichen Verringerung des Software- bzw. Hardware Aufwandes bei der Darstellung auf dem Bildgeber, so daß bei einer gleich leistungsfähigen Rechenanlage erheblich schnellere Bildfolgen dargestellt werden können oder bei gleicher Bildfrequenz erheblich höher aufgelöste Bilder mit mehr Bildpunkten erzielbar sind, als dies beim Stand der Technik der Fall ist. Dieser Vorteil ist für tomographische Messungen deshalb besonders wichtig, weil häufig die Detailbeobachtung bei derartigen Darstellungen besonders wichtig ist, etwa dann, wenn sich im Entstehen befindliche Geschwülste erkannt werden sollen, bzw. zur Verkürzung der gesamten Meßzeit, wenn man zunächst einmal ein grobes 3 D — Übersichtsbild sich erzeugt und dann erst — mit erhöhter Auflösung eine 2 D-Aufnahme macht.

Bevorzugt werden bei den optischen Mitteln entweder Linsen oder sphärische Spiegel verwendet.

Bei einer Ausführungsform der Erfindung werden zum Verkleinern und Rückvergrößern dieselben optischen Mittel verwendet, während bei einer weiteren Ausgestaltung der Erfindung zum Verkleinern und Rückvergrößern unterschiedliche Mittel Verwendung finden. Während bei der ersten Variante ein besonders kompakter Aufbau möglich ist, eröffnet die zweite Variante die Möglichkeit zusätzlicher Korrekturen optischer Fehler.

Um die räumliche Positionierung zwischen Bildgeber und Betrachter zu variieren, wird in einer Ausgestaltung der Erfindung ein senkrecht zu seiner Oberfläche ausgelenkter Planspiegel verwendet. Dieser Planspiegel ist im hier interessierenden Umfang völlig frei von Abbildungsfehlern, so daß auch von daher keine Korrektur des darzustellenden Bildes erforderlich ist.

Bei Verwendung dieses Planspiegels wird bevorzugt das vom Bildgeber dargestellte Bild über einen Hohlspiegel und eine bikonvexe Linse auf den Planspiegel abgebildet. Das Bild gelangt zur Rückvergrößerung wieder auf denselben Weg zurück und kann dann in vergrößerter Darstellung gegenüber dem Bild vor dem Planspiegel betrachtet werden. Dieser Aufbau erfordert demzufolge nur wenige optische Elemente und ist daher besonders einfach und kompakt.

In weiterer bevorzugter Ausgestaltung der Erfindung ist vor dem Bildgeber ein geneigter halbdurchlässiger Spiegel angeordnet, durch den hindurch das rückvergrößerte Bild betrachtbar ist. Das durch diese Anordnung bewirkte Abknicken der optischen Achse zwischen Bildgeber und beispielsweise dem genannten Hohlspiegel eröffnet für den Betrachter die Möglichkeit, noch näher an die dreidimensionale Darstellung heranzugehen, so daß er einmal diese Darstellung noch näher und damit genauer betrachten kann, zum anderen aber auch die Möglichkeit hat, « hinter » die dargestellten vorderen Elemente der dreidimensionalen Darstellung zu sehen, indem er seinen Betrachtungswinkel aus der optischen Achse heraus bewegt.

In weiterer bevorzugter Ausgestaltung der Erfindung wird, wie bereits angedeutet, zum Verändern der räumlichen Positionierung zwischen Bildgeber und Betrachter ein Element mit optisch durchlässigen Keilen verwendet, die zwischen sich einen zur optischen Achse geneigten Zwischenraum definieren, wobei der eine Teil senkrecht zur optischen Achse auslenkbar und der andere Teil raumfest ist. Durch Auslenken des beweglichen optischen Teiles wird der Zwischenraum in seiner Breite verändert, so daß für den Betrachter der Eindruck eines in der Tiefe bewegten Bildes entsteht.

Die letztgenannte Anordnung eignet sich besonders für solche erfindungsgemäßen Einrichtungen, bei denen für das Verkleinern und für das Rückvergrößern unterschiedliche optische Wegstrecken verwendet werden. Eine besonders gute Wirkung wird dabei dadurch erzielt, daß das vom Bildgeber dargestellte Bild über eine erste optische Wegstrecke, durch einen halbdurchlässigen Spiegel hindurch auf einen Insichreflektor (Katzenauge) gelangt und von dort über den halbdurchlässigen Spiegel in einen zweiten, vorzugsweise zu der ersten Wegstrecke identisch aufgebaute Wegstrecke, und daß das Keile aufweisende Element in der zweiten Wegstrecke angeordnet ist. Die Umlenkung des Strahles aus der ersten optischen Wegstrecke über den Insichreflektor in die zweite optische Wegstrecke eröffnet die Möglichkeit der Kompensation optischer Fehler. Sind beispielsweise die optischen Elemente der ersten Wegstrecke mit einem Astigmatismus behaftet, wird der sich dadurch einstellende Fehler durch die genannte Anordnung kompensiert.

Ein besonders einfacher Aufbau kann bei dieser Variante dadurch erzielt werden, daß die beiden optischen Wegstrecken jeweils zwei Sammellinsen aufweisen.

Weitere Vorteile ergeben sich aus der Beschreibung und der beigefügten Zeichnung.

Die Erfindung ist in der Zeichnung dargestellt und wird in der nachfolgenden Beschreibung näher erläutert.

Es zeigen :

Fig. 1 eine schematische Darstellung eines Kernspintomographen mit (in vergrößerter Darstellung) einer Schemazeichnung einer ersten Ausführungsform einer erfindungsgemäßen Einrichtung ;

Fig. 2 eine Schemazeichnung einer zweiten Ausführungsform einer erfindungsgemäßen Einrichtung mit getrennter Wegstrecke für Verkleinerung und Rückvergrößerung.

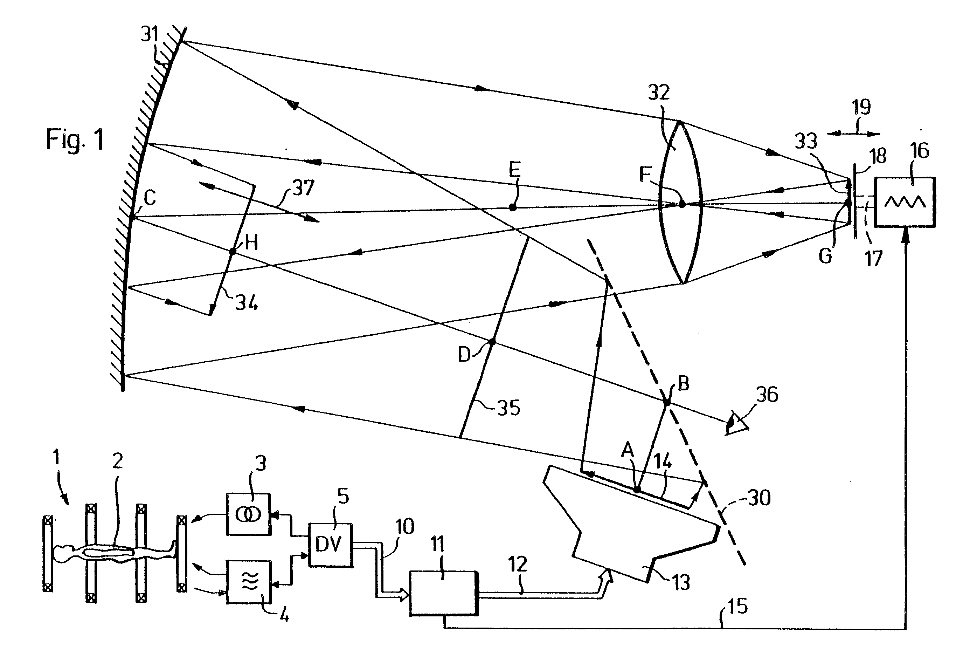

In Fig. 1 ist links unten schematisch ein sog. Kernspintomograph dargestellt. Ein Kernspintomograph umfaßt ein Magnetsystem 1, üblicherweise eine Anordnung aus mehreren Luftspulen. In der Spulenachse ist ein Patient 2 angeordnet. Die Spulen des Magnetsystems 1 sowie in Fig. 1 nicht dargestellte weitere, sog. Gradientenspulen werden von einem Netzgerät 3 gespeist. Weiterhin wird auf den Patienten 2 ein Hochfrequenzfeld über Spulen eingestrahlt, die von einer Hochfrequenzeinheit 4 gespeist werden. Die Hochfrequenzeinheit 4 empfängt auch die Meßsignale, die der u. a. Protonendichte in einer durch die genannten Größen definierten Querschnittsebene des Patienten 2 entsprechen. Diese Meßsignale werden einer Datenverarbeitungsanlage 5 zugeführt, die ihrerseits das Netzgerät 3 und die Hochfrequenzeinheit 4 steuert. Die Datenverarbeitungsanlage 5 ermittelt aus den empfangenen Meßsignalen eine zweidimensionale Darstellung, die der genannten Protonendichteverteilung in der ausgewählten Querschnittsebene des Patienten 2 entspricht. Die diesen zweidimensionalen Darstellungen entsprechenden Daten werden über eine Datenleitung 10 auf eine weitere Rechenanlage 11 geleitet. In dieser Rechenanlage 11 werden die hintereinanderliegenden Schnitten entsprechenden zweidimensionalen Darstellungen gespeichert und sequentiell über eine weitere Datenleitung 12 auf einen Bildgeber, vorzugsweise einen Monitor 13, weitergegeben. Das vom Monitor 13 abgebildete Bild ist in Fig. 1 mit 14 angedeutet. Darüber hinaus steuert die weitere Datenverarbeitungsanlage 11 über eine Steuerleitung 15 einen mechanischen Oszillator 16, der über ein Gestänge 17 einen Planspiegel 18 senkrecht zu dessen Oberfläche in einer Richtung 19 auslenkt.

Das vom Monitor 13 erzeugte Bild 14 wird über einen halbdurchlässigen Spiegel 30 auf einen raumfesten Hohlspiegel 31 und von dort über eine bikonvexe Linse 32 auf den Planspiegel 18 abgebildet, auf dem ein Bild 33 entsteht. Vom Planspiegel 18 wird der einfallende Lichtstrahl reflektiert und erzeugt nach Durchgang durch die bikonvexe Linse 32 und Reflexion durch den Hohlspiegel 31 ein im Raum stehendes Bild 34. Dieses Bild 34 kann so, als würde das Bild 14 von einem imaginären Spiegel 35 gespiegelt, von einem Betrachter 36 betrachtet werden.

Der sich beim Ausführungsbeispiel gemäß Fig. 1 ergebende Strahlengang wird im nachfolgenden anhand von Buchstaben A, B, C, D, E, F, G, H erläutert, die auf dem hin- bzw. hergehenden Strahl an den aus Fig. 1 ersichtlichen Stellen

liegen. Der in der Mitte des Bildes 14 liegende Punkt A wird im Punkt B auf den halbdurchlässigen Spiegel 30 gespiegelt und führt zum Punkt C auf den raumfesten Hohlspiegel 31. Der Abstand CE entspricht der Brennweite des Hohlspiegels 31. Der Abstand EF hingegen entspricht der Brennweite der bikonvexen Linse 32. Wie man demzufolge aus Fig. 1 erkennt, sind der Hohlspiegel 31 und die Linse 32 zueinander in einem Abstand CF angeordnet, der der Summe der Brennweiten CE und EF entspricht. Der Punkt G in der Mitte des Bildes 33 auf dem Planspiegel 18 liegt etwas außerhalb oder innerhalb der Brennweite der Sammellinse 32. Wie man zeigen kann, hat der « gemeinsame Brennpunkt » E der optischen Elemente 31 und 32 die Wirkung, daß bei einer Auslenkung des Planspiegels 18 in Richtung 19 und einer sich daraus ergebenden Auslenkung 37 des Bildes 34 im Punkte H eine Konstanz des Abbildungsmaßstabes auftritt.

Bezeichnet man die Brennweite CE des Hohlspiegels 31 mit f1 und die Brennweite EF der Linse 32 mit f2, ergibt sich ein Abbildungsmaßstab zwischen den Bildern 34 und 33 von (f1/f2). Der Hub des Planspiegels 18 in der Richtung 19 ist hingegen um einen Faktor $2 \times (f1/f2)^2$ geringer als der Hub des Bildes 34 in der Richtung 37. Der Faktor 2 vor der Klammer rührt dabei von der Abbildung über einen Spiegel, nämlich den Planspiegel 18, her.

Vereinfacht kann man sich die optische Darstellung aus Fig. 1 auch so vorstellen, als wäre im Punkt D, der vom Punkt C ebenso weit entfernt ist wie Punkt E, ein imaginärer Spiegel 35 (der real natürlich nicht existiert) vorhanden, auf dem der Betrachter 36 das Bild 14 des Monitors 13 sieht. Demzufolge ist der Abstand HD ebenso groß wie der Abstand DBA.

Insgesamt ergibt sich damit für den Betrachter 36 eine in der Richtung 37 im Raum hin- und herwandernde Abbildung eines Bildes 34 im Takte der Darstellungen der Bilder 14 auf dem Monitor 13, die mit der Auslenkung des Planspiegels 18 in Richtung 19 synchronisiert sind. Das genannte Verhältnis der Brennweiten von Hohlspiegel 31 und Linse 32 kann in einem praktischen Ausführungsbeispiel zwischen neun und zehn liegen, so daß bei einer etwa 7- bis 8-fachen Verkleinerung auf dem Planspiegel 18 dieser nur ca. 2 mm Hub in Richtung 19 ausführen muß, um einen Hub des Bildes 34 in Richtung 37 von 160 bis 200 mm zu erzeugen. Der genannte Hub von 2 mm Amplitude ist jedoch ohne weiteres mit einer Folgefrequenz von etwa 25 Hz möglich, wenn der Planspiegel 18 ca. 30 mm Durchmesser hat um das Bild 33 ca. 20 mm groß mit einer Randspiegelreserve zurückzuwerfen und das Bild 34 gegenüber 33 etwa 7 bis 8 mal größer ist, Dimensionen, die z. B. für die Darstellung von tomographischen Kopf-Aufnahmen ausreichen.

Der mechanische Oszillator 16 bewegt über das Gestänge 17 den Planspiegel 18 zeitlich streng linear, d. h. entsprechend z. B. einer Dreiecksfunktion. Insgesamt entsteht damit ein Bild 34, das sich zeitlich linear in Richtung 37 bei unverändertem Abbildungsmaßstab bewegt. Aus diesem Grunde können die Bilder 14 auf dem Monitor 13 in zeitlich konstanter Folge ohne jede weitere Korrektur des Bildverlaufes abgebildet werden und der Betrachter 36 erhält eine vollständige, abbildungsgetreue, dreidimensionale Darstellung.

Wie man weiter aus Fig. 1 erkennen kann, ist es auch möglich, den halbdurchlässigen Spiegel 30 fortzulassen, wenn der Betrachter 36 am Monitor 13 vorbei in Richtung auf den Hohlspiegel 31 schaut. Das Einfügen des halbdurchlässigen Spiegels 30 hat jedoch den Vorteil, daß der Betrachter 36 näher an das Bild 34 herankommt, so daß ein genaueres Betrachten dieses Bildes 34 möglich ist und der Betrachter 36 durch Auswandern aus der optischen Achse BDHC « hinter » die weiter vorne abgebildeten Elemente schauen kann.

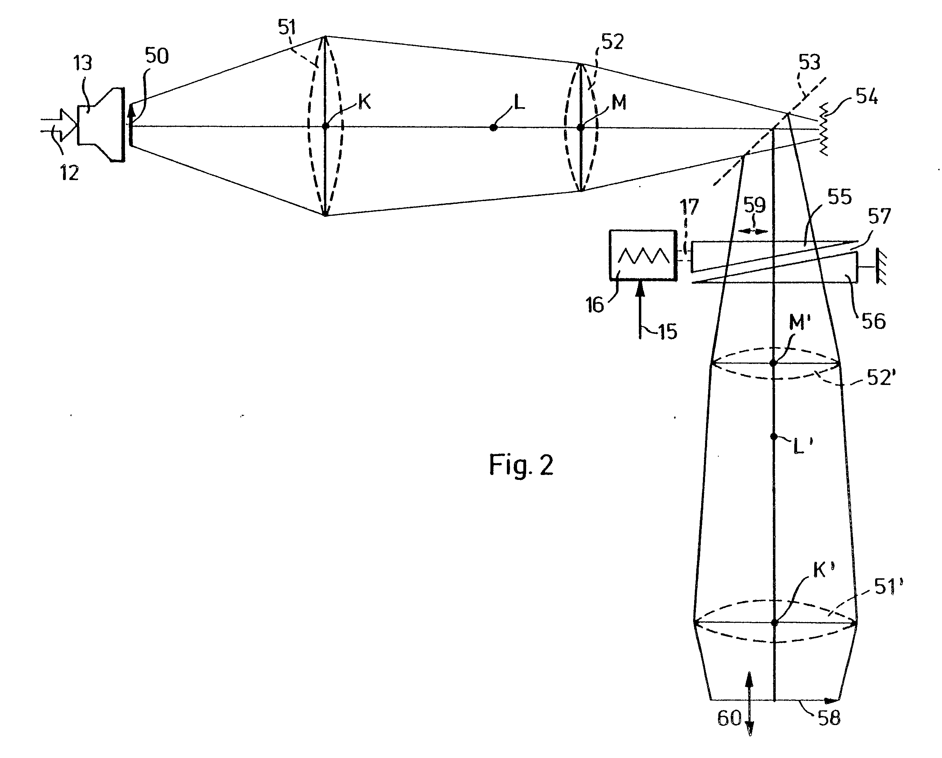

Das zweite Ausführungsbeispiel einer erfindungsgemäßen Einrichtung gemäß Fig. 2 unterscheidet sich in zwei wesentlichen Eigenschaften von denjenigen gemäß Fig. 1. Zum einen werden für die Verkleinerung des Bildes und für die Rückvergrößerung unterschiedliche Wegstrecken verwendet und zum anderen wird die räumliche Verschiebung des abgebildeten Bildes durch andere Mittel erzielt.

Im Eingang der Anordnung gemäß Fig. 2 erkennt man wieder den von der Datenleitung 12 gespeisten Monitor 13, der ein Bild 50 erzeugt. Dieses Bild 50 wird über eine erste Sammellinse 51 und zweite Sammellinse 52 durch einen halbdurchlässigen Spiegel 53 hindurch auf einen Insichreflektor 54 geleitet, wie er auch als « Katzenauge » bezeichnet wird. Die vom Insichreflektor 54 reflektierte Strahlung wird vom schräg gestellten halbdurchlässigen Spiegel 53 in eine zweite optische Wegstrecke reflektiert, der einmal aus zwei Sammellinsen 52' und 51' besteht, wobei die zweite optische Wegstrecke vorzugsweise identisch mit der ersten optischen Wegstrecke aufgebaut ist.

Um auch beim Ausführungsbeispiel gemäß Fig. 2 die Vorteile des konstanten Abbildungsmaßstabes zu erreichen, sind die Linsen 51, 52 in der ersten optischen Wegstrecke bzw. 51', 52' in der zweiten optischen Wegstrecke so angeordnet, daß sie voneinander einen Abstand KM haben, der der Summe der Brennweiten KL und LM entspricht. Der Punkt L ist somit wiederum der « gemeinsame » Brennpunkt der Linsen 51 und 52. Entsprechendes gilt für die Punkte K', L', M' der zweiten optischen Wegstrecke.

Um den räumlichen Eindruck in einem abgebildeten Bild 58 am Ende der zweiten optischen Wegstrecke zu erzielen, ist zwischen dem halbdurchlässigen Spiegel 53 und der Linse 52' der zweiten optischen Wegstrecke ein Element angeordnet, das aus zwei in Richtung der optischen Achse hintereinander angeordneten, optisch durchlässigen Keilen 55 und 56 besteht.

Diese Keile 55 und 56 definieren zwischen sich einen schräg zur optischen Achse liegenden Zwischenraum 57. Der Keil 55 wird vom mechanischen Oszillator 16 in einer Richtung 59 senkrecht zur optischen Achse bewegt, so daß sich die Breite des Zwischenraumes 57 im Takte der Auslenkung des Keiles 59 verändert. Entsprechend kommt es zu einer Wanderung des Bildes 58 in einer in der optischen Achse liegenden Richtung 60, so daß insgesamt wieder für einen hinter der zweiten optischen Wegstrecke sitzenden Beobachter ein räumlicher Eindruck entsteht.

Für die sich dabei ergebenden Größenverhältnisse und Abbildungsmaßstäbe gilt in entsprechender Weise das, was weiter oben zu Fig. 1 bereits ausgeführt wurde.

Die Anordnung gemäß Fig. 2 zeichnet sich dabei dadurch aus, daß der Insichreflektor 54 die auf ihn einstrahlende Strahlung in derselben Richtung, in der sie einstrahlt, wieder zurückstrahlt. Besitzen die in der ersten optischen Wegstrecke angeordneten Elemente, nämlich die Linsen 51 und 52, optische Fehler, beispielsweise einen Astigmatismus und eine Bildfeldwölbung, wird das mit den genannten Fehlern behaftete Lichtbündel über den halbdurchlässigen Spiegel 53 in die zweite optische Wegstrecke eingestrahlt, in der sich die genannten Fehler kompensieren, da die zur ersten optischen Wegstrecke identisch aufgebaute zweite optische Wegstrecke auch dieselben Fehler hat, jedoch aufgrund der Umlenkung durch den Insichtreflektor 54 in entgegengesetzter Richtung.

Insgesamt weist damit auch die Anordnung gemäß Fig. 2 die zum Ausführungsbeispiel gemäß Fig. 1 erwähnten Eigenschaften auf, nämlich die räumlich variierende, streng lineare Darstellung stets gleichgroßer zweidimensionaler Bilder, die erst eine nicht mehr korrekturbedürftige Darstellung der Monitorbilder mit konstanter Bildfolgefrequenz ermöglicht.

**Patentansprüche**

1. Einrichtung zum Erzeugen vollständiger dreidimensionaler Darstellungen eines räumlichen Objektes, insbesondere für einen Tomographen zum Darstellen des Inneren eines lebenden Körpers, mit einem Bildgeber (13) auf dem zeitlich nacheinander zweidimensionale, räumlich hintereinander liegenden Schnitten entsprechende erste Bilder (14 ; 50) dargestellt werden, und mit zwischen dem Bildgeber (13) und einem Betrachter (36) angeordneten optischen Abbildungsmitteln (18, 31, 32 ; 51 bis 57), die ein im Raum stehendes zweites, virtuelles Bild (34 ; 58) der ersten Bilder (14 ; 50) erzeugen, wobei die optischen Abbildungsmittel (18, 31, 32 ; 51 bis 57) ein vom Bildgeber (13) synchron gesteuertes Element (18 ; 55 bis 57) umfassen, das die räumliche Lage des zweiten Bildes (34 ; 58) relativ zum Betrachter in Abhängigkeit von der zeitlichen Folge der ersten Bilder (14 ; 50) variiert, dadurch gekennzeichnet, daß die optischen Abbildungsmittel (18, 31, 32 ; 51 bis 57) zum verkleinerten Abbilden der auf dem Bildgeber (13) dargestellten ersten Bilder (14 ; 50) in der Ebene des Elementes (18 ; 55 bis 57) und zum anschließenden Rückvergrößern in die Ebene des zweiten Bildes (34 ; 58) ausgebildet sind.

2. Einrichtung nach Anspruch 1, dadurch gekennzeichnet, daß die optischen Mittel mindestens zwei Sammelelemente (51, 52) umfassen, die zueinander in einem Abstand (CEF, KLM) angeordnet sind, der der Summe ihrer Brennweiten (CE, EF ; KL, LM) entspricht.

3. Einrichtung nach Anspruch 1 oder 2, dadurch gekennzeichnet, daß die optischen Mittel Linsen (32, 51, 52) aufweisen.

4. Einrichtung nach einem der Ansprüche 1 bis 3, dadurch gekennzeichnet, daß die optischen Mittel sphärische oder parabolische Spiegel (31) aufweisen.

5. Einrichtung nach einem der Ansprüche 1 bis 4, dadurch gekennzeichnet, daß zum Verkleinern und Rückvergrößern dieselben optischen Mittel Verwendung finden.

6. Einrichtung nach einem der Ansprüche 1 bis 4, dadurch gekennzeichnet, daß zum Verkleinern und Rückvergrößern zwei prinzipiell gleiche optische Mittel Verwendung finden.

7. Einrichtung nach einem der Ansprüche 1 bis 6, dadurch gekennzeichnet, daß das synchron gesteuerte Element ein senkrecht zu seiner Oberfläche ausgelenkter Planspiegel (18) ist.

8. Einrichtung nach Anspruch 5 und 7, dadurch gekennzeichnet, daß das vom Bildgeber dargestellte Bild (14) über einen Hohlspiegel (31) und eine bikonvexe Linse (32) auf dem Planspiegel (18) abgebildet wird.

9. Einrichtung nach Anspruch 8, dadurch gekennzeichnet, daß der Abstand (FG) des Planspiegels (18) von der Linse (32) etwas kürzer oder etwas länger als deren Brennweite (EF) ist.

10. Einrichtung nach einem der Ansprüche 7 bis 9, dadurch gekennzeichnet, daß vor dem Bildgeber ein geneigter halbdurchlässiger Spiegel (30) angeordnet ist, durch den hindurch das rückvergrößerte Bild (34) betrachtbar ist.

11. Einrichtung nach einem der Ansprüche 7 bis 10, dadurch gekennzeichnet, daß der Planspiegel (18) zeitlich linear ausgelenkt wird.

12. Einrichtung nach einem der Ansprüche 1 bis 6, dadurch gekennzeichnet, daß das Element zwei nebeneinander liegende, optisch durchlässige Keile (55, 56) aufweist, die zwischen sich einen zur optischen Achse geneigten Zwischenraum (57) definieren, daß der eine Keil (55) senkrecht zur optischen Achse auslenkbar und daß der andere Keil (56) raumfest ist.

13. Einrichtung nach Anspruch 6 und 12, dadurch gekennzeichnet, daß das vom Bildgeber dargestellte Bild (50) über eine erste optische Wegstrecke, durch einen halbdurchlässigen Spiegel (53) hindurch auf einen Insichreflektor (54) gelangt und von dort über den halbdurchlässigen Spiegel (53) in eine zweite, vorzugsweise zu der ersten Wegstrecke identisch aufgebaute Wegstrecke und daß das Keile (55, 56) aufweisende Element in der zweiten Wegstrecke angeordnet ist.

14. Einrichtung nach Anspruch 13, dadurch gekennzeichnet, daß die optischen Wegstrecken jeweils zwei Sammellinsen (51, 52 ; 51', 52') aufweisen.

15. Einrichtung nach einem der Ansprüche 12 bis 14, dadurch gekennzeichnet, daß der bewegliche Keil (55) zeitlich linear ausgelenkt wird.

16. Einrichtung nach einem der vorhergehenden Ansprüche, dadurch gekennzeichnet, daß die vom Bildgeber dargestellten Bilder (14, 50) tomographische Aufnahmen eines Kernspintomographen sind.

## Claims

1. Device for generating complete three-dimensional representations of a spatial object, especially for a tomograph for representing the interior of a living body, having an image monitor (13), on which two-dimensional first images (14 ; 50) corresponding to sections, spatially located one behind the other, are displayed sequentially in time, and optical imaging means (18, 31, 32 ; 51 to 57) which are arranged between the image monitor (13) and an observer (36) and which generate a second, virtual image (34 ; 58), located in space, of the first images (14 ; 50), the optical imaging means (18, 31, 32 ; 51 to 57) comprising an element (18 ; 55 to 57) which is synchronously controlled by the image monitor (13) and which varies the spatial position of the second image (34 ; 58) relative to the observer as a function of the time sequence of the first images (14 ; 50), characterized in that the optical imaging means (18 ; 31, 32 ; 51 to 57) are designed for producing a reduced image of the first images (14 ; 50), displayed on the image monitor (13), in the plane of the element (18 ; 55 to 57) and for subsequent re-enlargement into the plane of the second image (34 ; 58).

2. Device according to Claim 1, characterized in that the optical means comprise at least two collector elements (51, 52) which are arranged at a mutual distance (CEF, KLM) corresponding to the sum of their focal lengths (CE, EF ; KL, LM).

3. Device according to Claim 1 or 2, characterized in that the optical means contain lenses (32, 51, 52).

4. Device according to one of Claims 1 to 3, characterized in that the optical means contain spherical or parabolic mirrors (31).

5. Device according to one of Claims 1 to 4, characterized in that the same optical means are used for reducing and re-enlarging.

6. Device according to one of Claims 1 to 4, characterized in that two optical means, identical in principle, are used for reducing and re-enlarging.

7. Device according to one of Claims 1 to 6, characterized in that the synchronously controlled element is a plane mirror (18) deflected perpendicularly to its surface.

8. Device according to Claims 5 and 7, characterized in that an image of the image (14) displayed by the image monitor is produced on the plane mirror (18) by means of a concave mirror (31) and a biconvex lens (32).

9. Device according to Claim 8, characterized in that the distance (FG) of the plane mirror (18) from the lens (32) is a little shorter or a little longer than the focal length (EF) of the latter.

10. Device according to one of Claims 7 to 9, characterized in that, in front of the image monitor, an inclined semi-transparent mirror (30) is provided, through which the re-enlarged image (34) can be observed.

11. Device according to one of Claims 7 to 10, characterized in that the plane mirror (18) is deflected at linear time intervals.

12. Device according to one of Claims 1 to 6, characterized in that the element has two mutually adjacent, optically transparent wedges (55, 56) which, between them, define an interstice (57) inclined relative to the optical axis, that one wedge (55) is deflectable perpendicular to the optical axis and that the other wedge (56) is fixed in space.

13. Device according to Claims 6 and 12, characterized in that the image (50) displayed by the image monitor passes via a first optical path length and through a semi-transparent mirror (53) onto an equidirectional reflector (54) and from there via the semi-transparent mirror (53) into a second path length, preferably constructed identically to the first path length, and that the element having the wedges (55, 56) is arranged in the second path length.

14. Device according to Claim 13, characterized in that the optical path lengths each have two collector lenses (51, 52 ; 51', 52').

15. Device according to one of Claims 12 to 14, characterized in that the movable wedge (55) is deflected at linear time intervals.

16. Device according to one of the preceding claims, characterized in that the images (14, 50) displayed by the image monitor are tomographic images obtained from a nuclear magnetic resonance tomograph.

## Revendications

1. Installation pour obtenir des représentations tridimensionnelles complètes d'un objet à trois dimensions, en particulier pour un tomographe pour la représentation de l'intérieur d'un corps vivant, avec une source d'images (13) correspondant à des représentations successives des sections à deux dimensions se trouvent dans l'espace l'une derrière l'autre par rapport à une première image (14 ; 50) et avec des moyens (18, 31, 32 ; 51 à 57) de représentation optique disposées entre la source (13) et un observateur (36), moyens qui produisent une seconde image virtuelle (34 ; 58) dans l'espace des premières images (14 ; 50), les moyens de représentation optique (18, 31, 32 ; 51, 57) comprennent un élément (18, 55 à 57) commandé de manière synchrone par la source (13), qui fait varier dans l'espace la position de la seconde image (34 ; 58) par rapport à un observateur en fonction de la succession des premières images (14 ; 50), caractérisée en ce que les moyens de représentation optique (18, 31, 32 ; 51 à 57) sont agencés pour la représentation réduite des premières images (14 ; 50) fournies par la source (13), dans le plan de l'élément (18 ; 55 à 57), et ensuite pour la rétroprojection avec grossissement dans le plan de la seconde image (34 ; 58).

2. Installation selon la revendication 1, caractérisée en ce que les moyens optiques comprennent au moins deux éléments de concentration (51, 52), qui sont disposés à distance l'un de l'autre (CEF ; KLM), laquelle correspond à la somme de leur distance focale (CE, EF ; KL, LM).

3. Installation selon la revendication 1 ou 2, caractérisée en ce que les moyens optiques de concentration sont des lentilles (32, 51, 52).

4. Installation selon l'une des revendications 1 à 3, caractérisée en ce que les moyens optiques de concentration sont des miroirs sphériques ou paraboliques (31).

5. Installation selon l'une des revendications 1 à 4, caractérisée en ce qu'on utilise les mêmes moyens optiques pour la réduction et la rétroprojection avec agrandissement.

6. Installation selon l'une des revendications 1 à 4, caractérisée en ce que l'on utilise deux moyens optiques similaires pour la réduction et la rétroprojection avec agrandissement.

7. Installation selon l'une des revendications 1 à 6, caractérisée en ce que l'élément commandé de manière synchrone est un miroir plan déplaçable perpendiculairement par rapport à sa surface.

8. Installation selon l'une des revendications 5 et 7, caractérisée en ce que l'image (14) fournie par la source est projetée par un miroir concave (31) et une lentille biconvexe (32) sur le miroir plan (18).

9. Installation selon la revendication 8, caractérisée en ce que la distance (FG) du miroir plan (18) à la lentille (32) est un peu plus courte ou un peu plus longue que la distance focale de cette dernière.

10. Installation selon l'une des revendications 7 à 9, caractérisée en ce que devant la source est disposé un miroir semi-transparent (30) incliné, à travers lequel on peut observer l'image rétroprojetée et agrandie (34).

11. Installation selon l'une des revendications 7 à 10, caractérisée en ce que le miroir plan (18) est déplacé linéairement en fonction du temps.

12. Installation selon l'une des revendications 1 à 6, caractérisée en ce que l'élément présente deux coins (55, 56) voisins optiquement transparents, qui définissent entre eux un intervalle (57) incliné par rapport à l'axe optique, qu'un coin (55) est déplaçable perpendiculairement par rapport à l'axe optique et que l'autre coin (56) est fixe dans l'espace.

13. Installation selon l'une des revendications 6 à 12, caractérisée en ce que l'image (50) fournie par la source est projetée selon un premier trajet optique, en traversant un miroir semi-transparent (53) sur un réflecteur (54) et de là, par le miroir semi-transparent (53) selon un second trajet optique, de préférence construit de manière identique au premier et que l'élément présentant les coins (55, 56) est disposé sur le second trajet optique.

14. Installation selon la revendication 13, caractérisée en ce que les trajets optiques présentent chacun un ensemble de deux lentilles de concentration.

15. Installation selon l'une des revendications 12 à 14, caractérisée en ce que le coin mobile (55) est déplacé linéairement en fonction du temps.

16. Installation selon l'une des revendications précédentes, caractérisée en ce que les images fournies (14, 50) par la source sont des représentations tomographiques d'un tomographe à résonance magnétique nucléaire.

Fig. 1

0 154 624

Fig. 2

0 154 624